# EUROPEAN PATENT APPLICATION

(11) **EP 4 417 992 A1**
(43) Date of publication of application: **21.08.2024**
(21) Application number: 23157592.9
(22) Date of filing: 20.02.2023
(51) Int. Cl.: G01R 33/36

(54) **RADIO FREQUENCY RECEIVER SYSTEM AND METHOD**

(71) Applicant: Koninklijke Philips N.V., 5656 AG Eindhoven (NL)
(72) Inventor: LEUSSLER, Christoph Günther, Eindhoven (NL); VERNICKEL, Peter, Eindhoven (NL); FINDEKLEE, Christian, 5656AG Eindhoven (NL)
(74) Representative: Philips Intellectual Property & Standards

(57) **Abstract**

The invention pertains to a radio frequency receiver system (1) comprising a radio frequency coil circuit (2), a pre-amplifier (3) configured to receive magnetic resonance signals from the coil circuit and configured to output an amplified signal to a digitizer and control system (4), a detuning circuit (5) comprising a switch (6) configured to switch the radio frequency coil circuit between a detuned state and a tuned state based on a detune-command signal received by the detuning unit (5), and a single two-wire connection (7) which is configured to transmit electrical power to the pre-amplifier (3), to transmit the detune-command signal to the detuning circuit (5) and to carry the amplified receive signal. In this way, a radio frequency antenna system with improved characteristics is provided.

## Description

### FIELD OF THE INVENTION

The invention relates to the field of magnetic resonance imaging. In particular, the present invention relates to the field of radio frequency antenna systems for a magnetic resonance imaging device. The invention further relates to a radio frequency (RF) antenna or receiver assembly comprising an RF coil loop for pick-up of magnetic resonance signals, a pre-amplifier to amplify the magnetic resonance signals and a detuning circuit for switching the RF coil assembly between a detuned state ("off" state) and a tuned state ("on" state). The detuning circuit preferably includes a FET-based switch to switch the RF antenna assembly between the "on" state and the "off" state.

### BACKGROUND OF THE INVENTION

A part of every magnetic resonance imaging device is the radio frequency antenna system for receiving and converting the magnetic resonance signal. The radio frequency antenna system comprises a radio frequency coil, a matching network, a preamplifier and an analog-to-digital converter. The preamplifier supply voltage and the amplified signal are routed between antenna system and system back end using a first cable connection per antenna element. In magnetic resonance imaging the system integrated body coil generates the excitation magnetic field for the spin system causing a preceding relaxation. The precession of the net magnetization induces a current in the radio frequency coil via electromagnetic induction. The radio frequency coil generally comprises a conducting wire with an inductance and a coil resistance.

Like any radio frequency operated system, the radio frequency antenna system is subject to noise. Thereby, one of the most important requirements is to achieve a minimum noise figure. The lowest noise figure is achieved if the source impedance is matched to the noise impedance of the preamplifier. Especially for magnetic resonance imaging in the low field range (< 1 T), the signal-to-noise ratio, inter alia, depends on the patient geometry, the size of the bore and the relative position of the radio frequency coil within the bore. Further sources of noise are modulated power supplies that can lead to further increased noise or instability of preamplifiers, latency and gain instability leading to reduction of image quality.

With the advent of light weight digital RF coils for MRI, coils can be equipped with smart functionality to provide safe clinical workflow.

Magnet resonance (MR) coils for signal reception normally have two operational states: An "on" state, also called tuned state, which represents a low noise reception state for capturing of very weak (down to noise floor) nuclei signals. The other operational state is an "off' state, also called detuned state, which represents a passive state, in which the coils need to withstand strong RF pulses intended to excite nuclei. For switching, typically RF switches based on PIN diodes are used. The detune circuit requires a bias current though the diode of typically 80 mA. The supply of the detune circuit is realized using a second feeding supply cable between an individual antenna element and MR system. This makes the cable tree of the coil less flexible. One option would be to combine the first and second cable, in a 3-conductor structure, with e.g. shared return wire. But this greatly increases the risk of instability of preamplifiers for RF coils due to the strong transient currents on the cables. Furthermore, the control logic is expensive since the bias currents sum up to several Amperes in multi-channel coils in one of the operational phases. Strong losses have to be expected and the design of the feeding wires is challenging as the strong currents may not interfere with the B0 or gradient fields.

With the further advent of switches based on FETs (Field Effect Transistors), FET arrays or MEMs, RF currents, e.g. induced by the RF transmit pulse, are effectively blocked in the coil loop without the need of high detune currents. These newer detune circuits are fully voltage controlled, typically between 0 and 3V, and operate almost powerless in the two operational states of the coil.

Due to the complexity of the requirements, currently, two wire connections are needed to control a coil element. One connection is usually used for the RF signal and the DC supply of the preamplifier, whereas a second connection is used to route the detune current. This increases the complexity of trapping and contributes to electrical fields due to dual conductor feeding and trapping. In consequence this may cause signal integrity problems using digital solutions. Furthermore, this normally increases power consumption by additional digital electronics. Another requirement which permanently needs to be fulfilled is the patient's safety by control of the detune function.

WO 2007/138547 A1 describes a RF receiver assembly with a coaxial-based RF coil loop with a reactively coupled detune circuit. The switching is realized by a switching supply voltage for the preamplifier. The preamplifier is directly modulated by the switching supply voltage, which can lead to instability and image artefact issues. Hence remote detection of malfunction via a single two-wire or coaxial cable or connector remains a challenge.

### SUMMARY OF THE INVENTION

It is the object of the invention to provide a radio frequency antenna system with improved characteristics.

According to the invention, this object is addressed by the subject matter of the independent claims. Preferred embodiments of the invention are described in the dependent claims.

The invention relates to a radio frequency receiver system comprising a radio frequency coil circuit, a pre-amplifier configured to receive magnetic resonance signals from the coil circuit and configured to output an amplified signal to a digitizer and control system, the radio frequency receiver system further comprising a detuning circuit comprising a switch configured to switch the radio frequency coil circuit between a detuned state and a tuned state based on a detune-command signal received by the detuning unit, and a single two-wire or coaxial connection which is configured to transmit electrical power to the pre-amplifier, to transmit the detune-command signal to the detuning circuit and to carry the amplified receive signal.

According to the invention a single two-wire or coaxial cable is provided to supply electrical DC power to the pre-amplifier, to control the tune/detune state and to transfer the amplified magnetic resonance (MR) signal to and from the magnetic resonance examination system's (digital) control and reconstructor. The invention achieves to reduce the amount of cabling for data transfer, detuning control and power supply from/to the RF antenna assembly.

It has been discovered that a single cable control of the MRI control loop is advantageous using a select over a two-wire or coaxial signal to control the fully voltage controlled detuning circuit. The method provides an effective detuning of the MRI coil loop. The detection of the detuning circuit is realized via a nonlinear device or by impedance switching on a different frequency.

An antenna comprises an electrical element which in general can receive and/or transmit signals.

A digitizer and control system typically comprises a system that transforms or further processes the (raw) data to interpretable data like image data which normally consist of two-dimensional greyscale-images, also known as "slices", for visualization of contrasts. Hence a digitizer and control basically reconstructs the data that is acquired by the sensor system itself.

A diplexer usually frequency multiplexes two ports onto one port, but more than two ports may be multiplexed. The diplexer, being a passive device, is normally reciprocal: the device itself doesn't have a notion of input or output. The diplexer comprises typically a different device than a passive combiner or splitter. The ports of a diplexer are frequency selective; the ports of a combiner are not.

MR coils are turned on and off using radio frequency (RF) switches typically based on PIN-diodes. In general, a PIN-diode usually comprises a diode with a wide, undoped intrinsic semiconductor region between a p-type semiconductor and an n-type semiconductor region. The p-type and n-type regions are typically heavily doped in order to use them for ohmic contacts. The wide intrinsic region of a PIN-diode is in contrast to an ordinary p-n diode. The wide intrinsic region makes the PIN diode an inferior rectifier - which is one typical function of a diode - but it makes it applicable for attenuators, fast switches, photodetectors, and high-voltage power electronics applications.

In a preferred embodiment the radio frequency receiver system comprises a front-end diplexer at the side of the single two-wire or coaxial connection directed to the radio frequency coil circuit. Preferably the front-end diplexer is configured to isolate the pre-amplifier from the detune control and monitoring signal flow based on injected radio frequency signals.

In a preferred embodiment a back-end diplexer is located at the side of the single two-wire or coaxial cable directed to the digitizer and control system. Preferably the back-end diplexer is configured to isolate the digitizer and control system from other signals that are not required by the digitizer and control system.

In a preferred embodiment the back-end diplexer is configured to output the amplified magnetic resonance signal and receive an injected radio frequency signal generated by the digitizer and control system. Therefore the back-end diplexer preferably outputs the amplified MR-signal and receives an injected RF signal that is filtered to form the gate signal for the fully voltage controlled switch (i. e. a FET) to switch the detuning circuit.

In another preferred embodiment the front-end diplexers and the back-end diplexer are configured to isolate control signals, MR-data and electrical power. This further allows the use of only a single (coax) cable as a main connection to a MR-scanner and hence the reduction of cable connections by multiplexing of different frequencies and therefore also the use of different channels.

In a further preferred embodiment the digitizer and control system is configured to generate a RF signal modulated to control the tune/detune actors for the switch of the detuning circuit. A filtering and rectification is usually performed to correct the signals and obtain a signal that has only little or negligible deviations from the originally sent signal, because data transmissions suffers from many effects that unintentionally alter the original signal.

In another preferred embodiment the detuning circuit comprises a nonlinear device and/or an impedance switching on a different frequency. A nonlinear device usually comprises an electric component that has a characteristic response curve that is different from a linear curve. Thus a nonlinear component basically has a response or output signal that is not simply proportional to the input signal. Impedance switching preferably comprises the change of the complex resistance (impedance). By this a tuning or detuning effect can be achieved.

In a further preferred embodiment, the switch of the detuning circuit comprises a field effect transistor. The field-effect transistor (FET) is a type of transistor that uses an electric field to control and regulate the flow of current in a semiconductor. FETs (JFETs or MOSFETs) are devices with three terminals: source, gate, and drain. FETs control the flow of current by the application of a voltage to the gate, which in turn alters the conductivity between the drain and source. In a preferred embodiment more than one FET is used which allows to achieve a better switching performance. Such arrays of FETs are often available in a single package in combination with control and/or potentially monitoring logic. Single pole single throw (SPST) and single pole double throw (SPDT) are typical examples for such integrated circuits (ICs). The core switching actor may not only be a semiconductor, but also be based on other fully voltage controlled technology such as MEMS (Micro-Electro-Mechanical Systems). The SPST, SPDT and MEMS based devices are complex integrated circuits and can be directly be applied as switching actor.

In a preferred embodiment the detuning circuit is configured to be controlled by external detune commands. This allows an external control and hence also a remote control which is of high value in most applications. Preferably, external detune commands originate from a system host.

In a preferred embodiment the detuning circuit comprises a voltage-step-up circuit for matching the demands of signal transmission and tuning actors. This way for instance the injected RF power can be reduced. In general, a voltage-step-up circuit is a circuit which increases the voltage and it can function as an adjustable voltage regulator. The voltage-step-up circuit can comprise a Villard-type circuit.

According to another embodiment of the invention the switch of the detuning circuit is monitored by a detection circuit. Preferably the DC bias and/or select and/or control signals and/or output of the switch are monitored by the MRI system. The respective parameter can be monitored in real time. In case of a malfunction, the MRI scan can be stopped.

In a preferred embodiment the digitizer and control system comprises a digital synthesizer. A digital synthesizer is preferably a synthesizer that uses digital signal processing (DSP) techniques to combine different signals and/or frequencies.

The invention also relates to a magnetic resonance imaging system comprising a processor, a memory for storing machine executable instructions for execution by the processor and pulse sequence commands, and the already characterized radio frequency receiver system.

The invention also relates to a method for controlling a radio frequency receiver system, comprising the following steps: detecting a radio frequency signal with a radio frequency coil circuit, receiving the magnetic resonance signals from the radio frequency coil circuit with a pre-amplifier which sends an amplified signal to a digitizer and control system, switching the radio frequency coil circuit between an detuned state and a tuned state with a detuning circuit, wherein a single two-wire or coaxial connection is used for transmitting the electrical power to the pre-amplifier and for transmitting the detune command signal to the detuning circuit.

The invention further relates to a method comprising the steps of monitoring the detune circuit by (a) measuring the RF current in a parallel resonant detuning circuit, mixing the signal of the probe with a pilot signal and transmitting back the mixed signal output to an analogue to digital converter of the MR receive channel or to a separate dedicated input with less dynamic range or by (b) feeding a detector switch with the signal of the probe and detecting the change of the frequency selective impedance transition during transmission at the output of the feeding cable or by (c) a detector switch only grounding the DC voltage when a malfunction is detected.
The detector switch is typically located between the probe or a detector module and the two-wire connection. Preferably the detector switch comprises a FET or semiconductor based switch.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings
Fig. 1 schematically depicts a radio frequency receiver system according to a preferred embodiment of the invention with a single RF loop, a single micro coaxial cable or connector and a remote RF injection for fast coil detuning and
Fig. 2 schematically depicts a second radio frequency antenna system according to a preferred embodiment of the invention with an individual coil element with malfunction detection using a single coaxial connector.

### DETAILED DESCRIPTION OF EMBODIMENTS

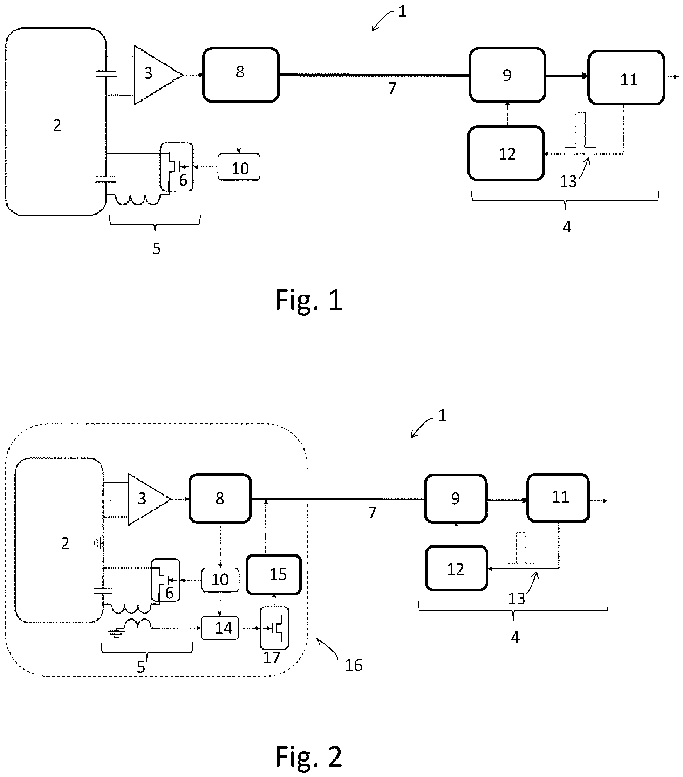

Fig. 1 schematically depicts a radio frequency receiver system 1 according to a preferred embodiment of the invention with a single radio frequency coil 2, a single micro coaxial cable or connector 7 and a remote radio frequency (RF) injection for fast coil detuning. As shown in Fig.1 a single coaxial connection 7 is used for the MRI pre-amplifier 3 and the control of the detune circuit 5. While the pre-amplifier 3 is supplied with a constant supply voltage (typically 9V), the detune circuit 5 is controlled via an injected RF signal generated by a transmitter. The RF control signal is injected via a front-end diplexer 8 into the coaxial connector and separated by a second diplexer, also named back-end diplexer 9, in the radio frequency coil circuit 2. The switched RF signal is filtered and rectified to generate a DC gate voltage for the switch 6. The single radio frequency coil typically consists of a loop using a wire as depicted in Fig. 1. The conductor loop can also be built up using a two-wire connection like a coaxial cable or combinations of distributed capacitor with discrete capacitors. The capacitor in the detune circuit 5 can be a local capacitor or a distributed capacitor, transmission line or any kind of device (coil, transmission line etc.) The switching device 6 generates - in general by the on off switching in combination with a impedance - a on and off state of the coil. A voltage-step-up circuit 10, in particular a Villard cascade voltage multiplier, can be further applied to reduce the injected RF power, especially for matching the demands of signal transmission and tuning actors. For example, MEMS switches require high control voltages in the range of 100V at virtually zero current. Such a high voltage is hard to generate or transmit or diplexed. The pre-amplifier 3 is isolated via the front-end diplexer 8 from the injected control signal. A pulsed RF power of 50 mW can generate 1.58V rms, which can be further increased using a passive voltage doubler.

The transmitter for the RF pilot or select signal is realized as a digital synthesizer. The frequency, amplitude and phase can be controlled by the digital receiver 11. The digital receiver 11 typically comprises a fully integrated circuit, which incorporates a digital synthesizer, or the digital synthesizer is located remotely and routed to the digital receiver 11. A local digital synthesizer can be located at the digitizer and control system 4 and be controlled via the digital receiver 11 or by a further digital control signal optically or galvanically. A further option is for instance to use a fixed analog signal and/or a quartz oscillator. The digitizer and control system 4 can be used for managing the tune/detune state timing and malfunctions reported by the coil element (16). Further it can be used for digitizing the RX signal and generating the supply voltage for the preamplifier. The digitizer and control system's 4 output to the right (see arrow in Fig. 2) can be fed to a reconstructor (not shown). Simultaneously to/from further not shown units it can receive control commands and a synchronization signal. The signal generator 12 modulates its output according to blank control 13. The diplexer 9 performs a mixing of the signals to one channel. To transmit all signals over a single two-wire connection a DC signal controlling is enhanced and replaced by the switching actors of the coil from a two stage DC signal (e.g. -5/+5V or 0 and 3V) to a signal with an AC signal as a carrier of the control demand.

The frequency of the RF detune signal TX 12 is selected so that the three basic signals (DC preamp supply, RF detune signal (TX) and MRI (RX) signal) can easily be separated.

In a very simple set-up, the RF detune signal (TX) signal is a simple (pulsed) DC voltage overlayed to the DC preamp supply voltage. The pulsed signal can be provided with the help of the digital receiver 11 and a blank control signal 13. For example, should the coil be tuned or detuned, depending on the implementation of the RF detune signal 12, the signal high corresponds to detuned and low (blank) corresponds to tuned or vice versa. In a simple implementation the RF detune signal 12 is a crystal oscillator with an amplifier for the oscillator output, then blank means not to amplify the output in case it is not needed.

The modular design can be applied at different MRI field strength or nuclei. Further the amplitude of the switching carrier is adapted to the correct and safe control of the detuning circuit (5). The pilot signal can also be modulated to optimize the switching behaviour of the rectifier circuit and to reduce latency.

In the following three possibilities are described for monitoring the detune circuit 5. Fig. 2 shows an individual coil element with malfunction detection using single coaxial connector 7. The signal of the probe is feeding a FET transistor, which shortens the coaxial connector 7 via a filter at a reference plane (location at output at pre-amplifier 3). The change of the frequency selective impedance transition during transmit can be detected at the output of the feeding cable.

The second possibility for monitoring the detune circuit 5 - especially in the framework of SAR safety monitoring - can be realized by measuring the current in the parallel resonant detuning circuit. The measurement can be performed by an inductive/capacitive coupling probe. The signal of the probe is mixed (non-linear device, diode, mixer) with the select/pilot signal and the mixed signal output is transmitted back to an ADC of the MR receive channel 11 or to a separate dedicated input with less dynamic range. For this option of monitoring the detune circuit, the FET and a notch filter 15 are replaced by a mixer.

The third possibility for monitoring the detune circuit 5 is that the switch 6 or field effect transistor (FET) only grounds the applied DC voltage when there is a malfunction. The DC voltage can easily be detected via a single coaxial cable or connector.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

| | |
|---|---|
| Radio frequency receiver system | 1 |
| Radio frequency coil circuit | 2 |
| Pre-amplifier | 3 |
| Digitizer and control system | 4 |
| Detuning circuit | 5 |
| Switch | 6 |
| Two-wire connection | 7 |
| Diplexer | 8, 9 |
| Voltage-step-up circuit | 10 |
| Digital receiver / MR receive channel | 11 |
| RF detune signal (Tx) | 12 |
| Blank control | 13 |
| Detector | 14 |
| Notch filter | 15 |
| Individual coil element | 16 |
| Detector switch | 17 |

## Claims

1. Radio frequency receiver system (1) comprising
a radio frequency coil circuit (2),
a pre-amplifier (3) configured to receive magnetic resonance signals from the coil circuit and configured to output an amplified signal to a digitizer and control system (4),
a detuning circuit (5) comprising a switch (6) configured to switch the radio frequency coil circuit between a detuned state and a tuned state based on a detune-command signal received by the detuning unit (5), and
a single two-wire connection (7) which is configured to transmit electrical power to the pre-amplifier (3), to transmit the detune-command signal to the detuning circuit (5) and to carry the amplified receive signal.

2. Radio frequency receiver system (1) according to claim 1, which comprises a front-end diplexer (8) at the side of the single two-wire connection (7) directed to the radio frequency coil circuit (2).

3. Radio frequency receiver system (1) according to claim 2, wherein the front-end diplexer (8) is configured to isolate the pre-amplifier (3) from the detune control and monitoring signal flow based on injected radio frequency signals.

4. Radio frequency receiver system (1) of any of claims 1 to 3, wherein the radio frequency receiver system (1) comprises a back-end diplexer (9) at the side of the single two-wire cable directed to the digitizer and control system (4).

5. Radio frequency receiver system (1) of claim 4, wherein the back-end diplexer (9) is configured to output the amplified magnetic resonance signal towards the digital receiver and to forward a detune control signal towards the front end in form of an injected radio frequency signal generated by the digitizer and control system (4).

6. Radio frequency receiver system (1) according to any of claims 2 to 5, wherein the front-end diplexers (8) and the back-end diplexer are configured to isolate control signals, MR-data and electrical power.

7. Radio frequency receiver system (1) according to any of the preceding claims, wherein the digitizer and control system (4) is configured to generate a RF signal modulated to control the tune/detune actors for the switch (6) of the detuning circuit.

8. Radio frequency receiver system (1) according to any of the preceding claims, wherein the detuning circuit (6) comprises a nonlinear device and/or an impedance switching on a different frequency.

9. Radio frequency receiver system (1) according to any of the preceding claims, wherein the switch (6) of the detuning circuit (5) comprises at least one field effect transistor.

10. Radio frequency receiver system (1) according to any of the preceding claims, wherein the detuning circuit (6) is configured to be controlled by external detune commands.

11. Radio frequency receiver system (1) according to any of the preceding claims, wherein the detuning circuit (6) comprises a voltage-step-up circuit (10) for matching the demands of signal transmission and tuning actors.

12. Radio frequency receiver system (1) according to any of the preceding claims, wherein the digitizer and control system (4) comprises a digital synthesizer.

13. A magnetic resonance imaging system comprising
a processor,
a memory for storing machine executable instructions for execution by the processor and pulse sequence commands, and
a radio frequency receiver system (1) according to any of the preceding claims.

14. Method for controlling a radio frequency receiver system (1), comprising the following steps:
detecting a radio frequency signal with a radio frequency coil circuit (2),
receiving the magnetic resonance signals from the radio frequency coil circuit (2) with a pre-amplifier (3) which sends an amplified signal to a digitizer and control system (4),
switching the radio frequency coil circuit (2) between a detuned state and a tuned state with a detuning circuit (5), wherein
a single two-wire connection (7) is used for transmitting the electrical power to the pre-amplifier (3) and for transmitting the detune command signal to the detuning circuit (5).

15. Method according to claim 14, comprising the steps of monitoring the detune circuit by
(a) measuring the RF current in a parallel resonant detuning circuit,
mixing the signal of the probe with a pilot signal and
transmitting back the mixed signal output to an analogue to digital converter of the MR receive channel (11) or to a separate dedicated input with less dynamic range.
or by
(b) feeding a detector switch (17) with the signal of the probe and
detecting the change of the frequency selective impedance transition during transmission at the output of the feeding cable
or by
(c) a detector switch (17) only grounding the DC voltage when a malfunction is detected.
